# EUROPÄISCHE PATENTSCHRIFT

(11) **EP 0 850 799 B1**
(45) Veröffentlichungstag und Bekanntmachung des Hinweises auf die Patenterteilung: **14.08.2002**
(21) Anmeldenummer: 97120607.3
(22) Anmeldetag: 25.11.1997
(51) Int. Cl.: B60K 35/00, G09F 13/04

(54) **Anzeigeeinheit mit durchleuchtbarem Anzeigeelement**
Indication unit with transparent indicating element
Unité de visualisation avec élément d'affichage transparent

(30) Priorität: 24.12.1996 DE 19654418
(43) Veröffentlichungstag der Anmeldung: 01.07.1998
(73) Patentinhaber: Siemens Aktiengesellschaft, 80333 München (DE)
(72) Erfinder: Noll, Heinrich Dr., 64823 Gross-Umstadt (DE); Henz, Friedrich, 60529 Frankfurt (DE); Schaper, Thomas, 64850 Schaafheim (DE)

(56) Entgegenhaltungen:
- EP-A- 0 405 286
- EP-A- 0 588 504
- EP-A- 0 606 939
- PATENT ABSTRACTS OF JAPAN vol. 095, no. 002, 31. März 1995 -& JP 06 308485 A (HITACHI LTD), 4. November 1994
- PATENT ABSTRACTS OF JAPAN vol. 096, no. 009, 30. September 1996 & JP 08 129175 A (SEKISUI CHEM CO LTD), 21. Mai 1996

## Beschreibung

Die Erfindung betrifft eine Anzeigeeinheit mit einem durchleuchtbaren Anzeigeelement, auf dessen Rückseite eine Lichtquelle und zwischen Lichtquelle und Anzeigeelement ein Diffusor angeordnet ist.

Eine Anzeigeeinheit gemäß dem Oberbegriff von Anspruch 1 ist aus EP 0 606 939 A1 bekannt.

Weiterhin ist z.B. eine Anzeigeeinheit mit einer Flüssigkristallzelle, mit einem auf der einem Beobachter abgewandten Seite der Flüssigkristallzelle angeordneten Lichtkasten und einer darin angeordneten Lichtquelle zur transmissiven Beleuchtung der Flüssigkristallzelle bekannt. Zwischen der Lichtquelle und der Flüssigkristallzelle ist eine transparente, lichtstreuende Streuscheibe angeordnet. Die Streuscheibe bewirkt eine Vergleichmäßigung des von der Lichtquelle ausgesandten Lichtes und somit eine Erhellung der Flüssigkristallzelle ohne größere Helligkeitssprünge in der Anzeigeebene.

Dennoch erscheint in dem der Lichtquelle gegenüberliegenden Anzeigebereich ein Lichtfleck. Um diesen Effekt nicht zu verstärken und um eine Erwärmung der Anzeigeeinheit nicht über ein zulässiges Maß ansteigen zu lassen, ist es bei der bekannten Anzeigeeinheit nicht möglich, beliebig leuchtstarke Lichtquellen einzusetzen. Damit ist aber auch der erreichbaren Helligkeit in einem Anzeigebereich eine unerwünschte Grenze gesetzt.

Um hier Abhilfe zu schaffen, ist es Aufgabe der vorliegenden Erfindung, eine Anzeigeeinheit mit einem durchleuchtbaren Anzeigeelement der genannten Art so zu gestalten, daß eine hohe Helligkeit in einem Anzeigebereich gewährleistet ist, ohne daß eine leistungsstärkere Lichtquelle verwendet wird. Dabei soll gleichzeitig die Montage der Anzeigeeinheit einfach und die Bauteilevielfalt gering gehalten werden.

Die Aufgabe wird erfindungsgemäß durch die Merkmale des Anspruchs 1 gelöst. Zwischen der Lichtquelle und dem Anzeigeelement ist ein in etwa scheibenförmiges, lichtklares Element angeordnet, dessen dem Anzeigeelement zugewandte Oberfläche in etwa pyramidenförmig gerastert ist und an dessen dem Anzeigeelement abgewandten Seite der Diffusor angeordnet ist.

Im Gegensatz zu bekannten Einrichtungen kann durch eine derart ausgebildete Anzeigeeinheit eine höhere Leuchtdichte in einer typischen Beobachtungsrichtung erreicht und die Erzeugung von Lichtflecken auf dem Anzeigeelement vermieden werden.

In einer bevorzugten Ausführungsform ist das Anzeigeelement eine Sichtscheibe, die z.B. Bestandteil eines Kombinationsinstrumentes eines Kraftfahrzeugs sein kann. Vorzugsweise ist die Sichtscheibe farbig und kann in einer weiteren vorteilhaften Ausführungsform Symbole und/oder Schriftzeichen aufweisen. Damit ist der von einem aktivierten Anzeigeelement ausgehende Informationsgehalt weiter zu steigern.

Besonders vorteilhaft ist das Anzeigeelement eine Flüssigkristallzelle. Insbesondere bei Flüssigkristallzellen wird zur Informationsdarstellung sehr viel Licht benötigt. Einer Erhöhung der Anzahl der Lichtquellen oder dem Einsatz von stärkeren Lichtquellen stehen jedoch ein hoher Platzbedarf, eine unzulässig hohe Wärmeerzeugung und höhere Kosten entgegen. vorteilhaft sein, wenn der Diffusor aus einem transparenten Werkstoff besteht, in dem verteilt Streupigmente oder Streuteilchen angeordnet sind. Die lichtstreuenden Eigenschaften des Diffusors können so weiter verbessert werden. Ist der Diffusor scheibenförmig, so kann er besonders einfach hergestellt und in die Anzeigeeinheit eingebaut werden.

In der erfindungsgemäßen Ausgestaltung der Anzeigeeinheit ist der Diffusor ein einziges Bauteil bildend mit dem lichtklaren Element verbunden. Dabei ist dieses Bauteil als 2-Komponenten-Spritzteil ausgeführt. Ein solches Spritzteil ist in besonders wenigen Verfahrensgängen herstellbar und weist in seinem Inneren, d.h. zwischen Diffusor und lichtklarem Element, keine Übergangsfläche auf. Das Nichtvorhandensein einer solchen Lichtübergangsfläche ist besonders günstig, da hierdurch der Lichtverlust minimiert wird. An einer Übergangsfläche treten üblicherweise Lichtverluste von mindestens 4% auf.

Vorteilhaft ist die Lichtquelle eine LED oder eine Glühlampe, wodurch ein besonders einfacher Aufbau der Anzeigeeinheit und eine kostengünstige Herstellung zu erreichen ist. Da die erfindungsgemäße Anzeigeeinheit aber auch bedeutende Vorteile bei der Beleuchtung von größeren Anzeigeelementen, z.B. LCD-Farbbildschirmen, bietet, ist es auch günstig, wenn die Lichtquelle eine Leuchtstofflampe ist. Wird eine farbige Durchleuchtung des Anzeigeelements gewünscht, so kann die Lichtquelle vorteilhaft farbiges Licht ausstrahlen. Der gleiche Effekt kann erreicht werden, wenn der Diffusor farbig ist.

Vorzugsweise weist die in etwa pyramidenförmige Rasterung der Oberfläche des lichtklaren Elements Pyramiden mit quadratischer oder rechteckiger Grundfläche auf. Da die Oberfläche ein lichtaktives Element ist, muß auf ihre optische Qualität besonderer Wert gelegt werden. Eine Rasterung mit quadratische oder rechteckige Grundflächen aufweisenden Pyramiden läßt sich besonders einfach herstellen und gewährleistet bereits eine bedeutende Lichtsammlung. Es ist notwendig, die Pyramidenstruktur so fein zu gestalten, daß diese auf dem Anzeigeelement nicht sichtbar ist, um keinen optisch störenden Effekt zu erhalten.

Die pyramidenförmige Oberflächenstruktur ist abstimmbar auf die geometrische Form des Anzeigeelements und den im vorgesehenen Einsatzfall typischerweise auftretenden Betrachtungswinkel. Dementsprechend kann die Struktur so gewählt werden, daß das Anzeigeelement unter vorgenanntem Betrachtungswinkel besonders hell ausgeleuchtet ist. Die in etwa pyramidenförmige Rasterung der Oberfläche des lichtklaren Elements weist daher vorzugsweise Pyramiden mit drei- oder mehreckiger Grundfläche auf.

Für bestimmte Einsatzfälle, z.B. wenn die an sich unerwünscht einen Lichtfleck erzeugenden von der Lichtquelle in etwa senkrecht zu dem Anzeigeelement ausgesandten Lichtstrahlen direkt zu einem Beobachter gelangen sollen, kann es günstig sein, wenn die in etwa pyramidenförmige Rasterung der Oberfläche des lichtklaren Elements Pyramidenstümpfe aufweist. Die Herstellung vereinfachend ist es, wenn die in etwa pyramidenförmige Rasterung der Oberfläche des lichtklaren Elements Pyramiden und/oder Pyramidenstümpfe mit einheitlicher Grundfläche und Höhe aufweist. Zur Erzeugung spezieller Effekte, z.B. einer stärkeren Lichtsammlung in den Randbereichen des Anzeigeelements, kann es von Vorteil sein, wenn die in etwa pyramidenförmige Rasterung der Oberfläche des lichtklaren Elements Pyramiden und/oder Pyramidenstümpfe mit unterschiedlicher Grundfläche und/oder Höhe aufweist. Dabei kann es, abhängig von der jeweils gewünschten Durchleuchtungswirkung, sowohl günstig sein, die unterschiedlichen Strukturen jeweils gleichmäßig über die Anzeigeebene zu verteilen, als auch, in einzelnen Bereichen der Anzeigeebene wiederum einheitliche Strukturen vorzusehen.

Aufgrund der lichtausrichtenden Wirkung des lichtklaren Elements ist es von besonderer Wichtigkeit, dieses Element in einer festgelegten, von seiner Oberflächenstruktur und dem Betrachtungswinkel abhängigen Position im Verhältnis zum Anzeigeelement in die Anzeigeeinheit einzubauen. Hierfür weist das lichtklare Element vorzugsweise eine Codierung auf.

Anhand von in den beigefügten Zeichnungen dargestellten Ausführungsbeispielen wird die Erfindung im folgenden näher erläutert. Es zeigt:
- Fig. 1: eine Anzeigeeinheit in geschnittener Darstellung, nicht zur Erfindung gehörig.
- Fig. 2: einen Ausschnitt einer erfindungsgemäßen Anzeigeeinheit in einer zweiten Ausführungsform in geschnittener Darstellung,
- Fig. 3: einen Diffusor und ein lichtklares Element, ein einziges Bauteil bildend, in verschiedenen Ansichten und
- Fig. 4: das Bauteil aus Fig. 3 in ausschnittsweiser und perspektivischer Darstellung.

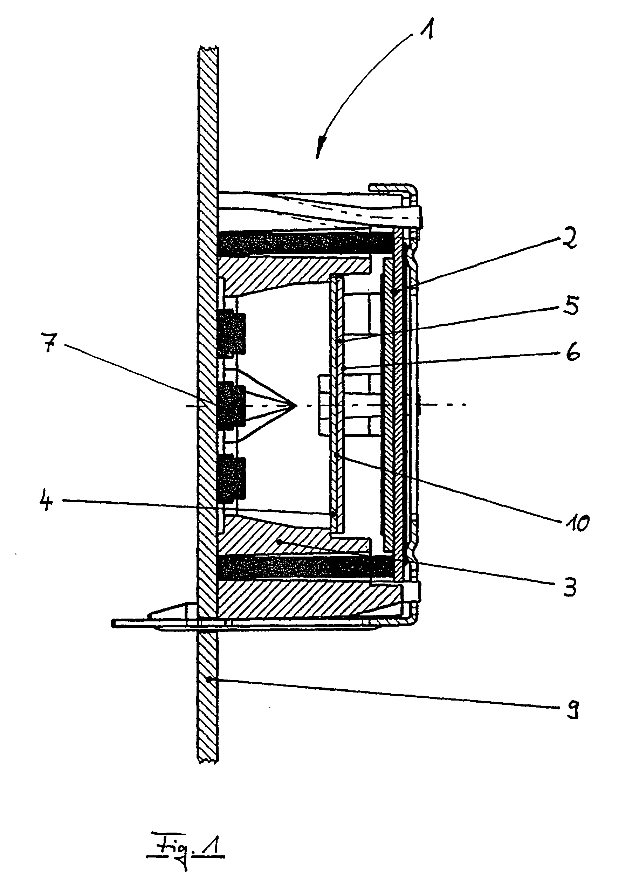

Eine in Fig. 1 dargestellte Anzeigeeinheit 1 wird von einer Leiterplatte 9 gehalten. Auf der Leiterplatte 9 sind Lichtquellen 7 und ein als Gehäusebauteil ausgebildeter Lichtkasten 3 angeordnet. Ein Anzeigeelement 2, in diesem Fall eine Flüssigkristallzelle, dient der Informationsdarstellung und bildet den frontseitigen Abschluß der Anzeigeeinheit 1. Das Anzeigeelement 2 ist von den Lichtquellen 7 durchleuchtbar.

Zwischen Anzeigeelement 2 und Lichtquellen 7 ist ein lichtklares Element 5 mit einer gerasterten Oberfläche 6 sowie ein Diffusor 4 angeordnet. Zwischen Diffusor 4 und lichtklarem Element 5 befindet sich ein Luftspalt 10, der einer auf Kondenswasser zurückzuführenden Bildung von Wasserflecken entgegenwirkt. Das lichtklare Element 5 ist mit seiner gerasterten Oberfläche 6 dem Anzeigeelement 2 und der Diffusor 4 den Lichtquellen 7 zugewandt.

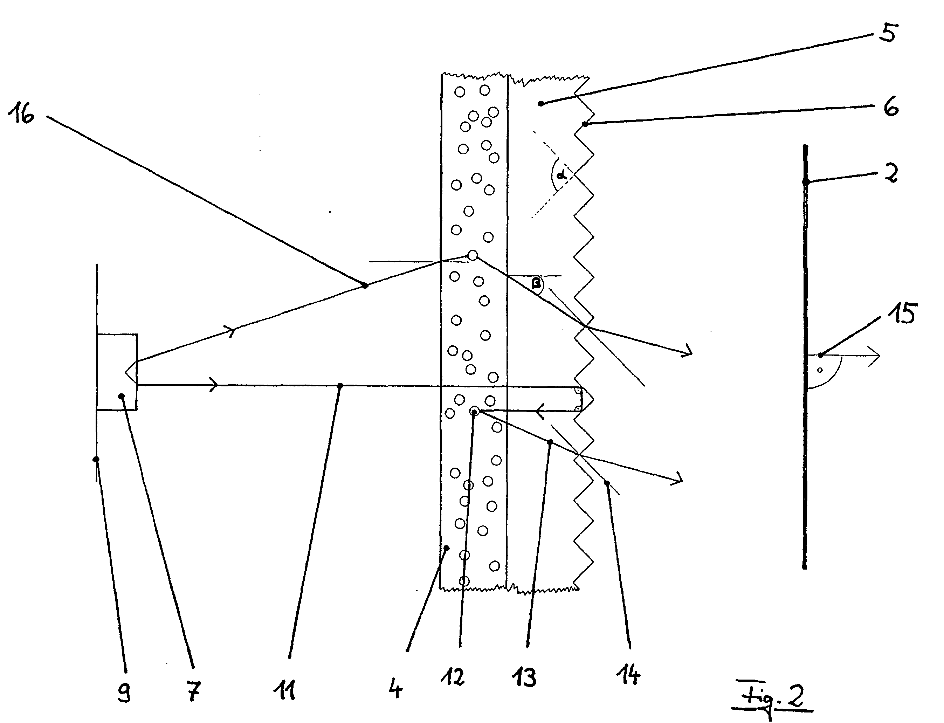

Die Wirkung einer Pyramidenstruktur der gerasterten Oberfläche 6 des lichtklaren Elements 5 wird in Fig. 2 verdeutlicht. Ein Lichtstrahl 11, der senkrecht auf die Diffusorscheibe 4 trifft, wird durch die Pyramidenstruktur (mit einem Winkel α von 90°) um 180° umgelenkt und zurückreflektiert. Trifft er nach Wiedereintritt in den Diffusor 4 auf ein Streupigment 12, so wird er gestreut und kann wieder unter einem bestimmten Winkel auf die Pyramidenstruktur der Oberfläche 6 treffen (Lichtstrahl 13). Hier wird der Lichtstrahl 13 nach dem Brechungsgesetz vom Lot 14 weg gebrochen. Dies bedeutet jedoch, daß er zur Anzeigeelement-Normalen 15 hin gebrochen wird. Durch die Totalreflektion der in etwa senkrecht auf den Diffusor 4 und das lichtklare Element 5 auftreffenden Lichtstrahlen werden helle Lichtflecke in den Lichtquellen 7 gegenüberliegenden Anzeigebereichen auf dem Anzeigeelement 2 vermieden. Das Brechen von die Oberfläche 6 durchtretenden Lichtstrahlen zur Anzeigeelement-Normalen hin führt zu einer erhöhten Leuchtdichte in Richtung der Anzeigeelement-Normalen. Üblicherweise werden Anzeigen aus dieser Richtung betrachtet, so daß für den Beobachter eine hohe Anzeigehelligkeit gewährleistet ist.

Ist der Winkel β, unter dem ein Lichtstrahl auf die Oberfläche 6 auftrifft, größer als 45° minus dem Grenzwinkel der Totalreflektion, so wird der Lichtstrahl an der Oberfläche (Pyramidenstruktur) gebrochen, sonst wird er reflektiert. Wird ein Lichtstrahl 16 der Lichtquelle 7 an einem Pigment in der Diffusorscheibe 4 gestreut und trifft so unter einem größeren Winkel von der Anzeigeelement-Normalen 15 aus gesehen auf die Pyramidenstruktur, so wird er wieder zur Anzeigeelement-Normalen 15 hin gebrochen. Vorgenannte Effekte führen zu einer größeren Leuchtdichte in Richtung der Anzeigeelement-Normalen und zu einer gleichmäßigeren Ausleuchtung des Anzeigeelements. Wird das Anzeigeelement bevorzugt aus einer anderen als der der Anzeigeelement-Normalen entsprechenden Richtung betrachtet, so ist die Oberflächenstruktur des lichtklaren Elements so zu wählen, daß in dieser anderen Richtung eine größere Leuchtdichte vorliegt.

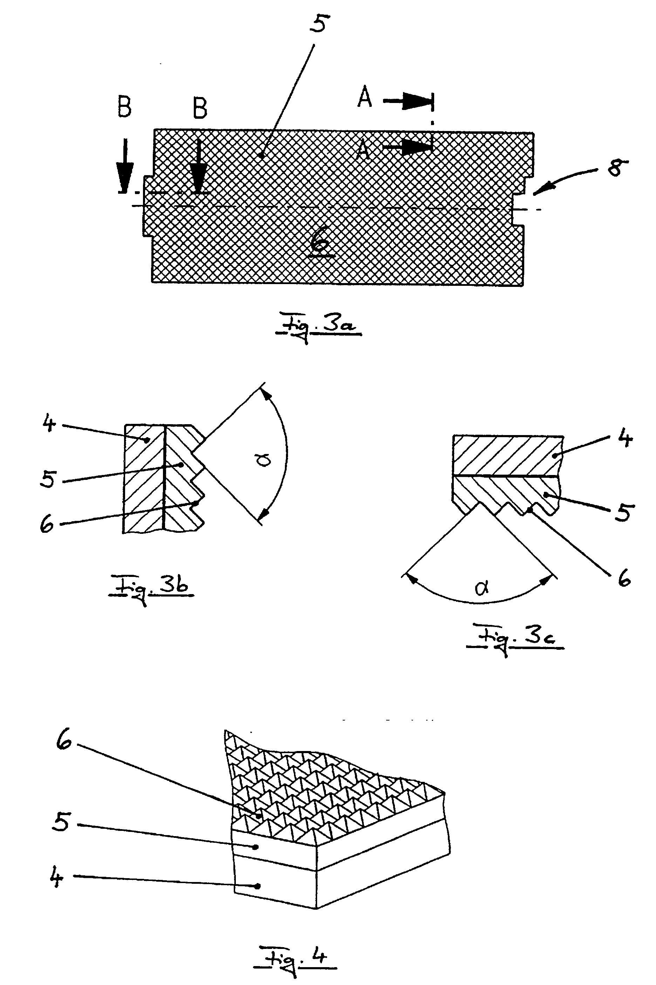

Fig. 3a zeigt eine Vorderansicht einer eine Pyramidenstruktur aufweisenden gerasterten Oberfläche 6 eines lichtklaren Elements 5. Eine Codierung 8 stellt die richtige Einbaulage bei der Montage des lichtklaren Elements 5 in der Anzeigeeinheit sicher. Wie den Fig. 3b und 3c, die Schnitte entlang der Linien A-A und B-B des Bauteils aus Fig. 3a darstellen, zu entnehmen ist, ist das lichtklare Element 5 ein einziges Bauteil bildend mit dem Diffusor 4 verbunden. Dieses Bauteil ist z.B. ein 2-Komponenten-Spritzteil aus Kunststoff. Der Winkel α zwischen den Pyramiden auf der gerasterten Oberfläche 6 beträgt hier in etwa 90°.

Das 2-Komponenten-Spritzteil aus Fig. 3a ist - die Pyramidenstruktur der Oberfläche 6 des lichtklaren Elements 5 verdeutlichend - in Fig. 4 perspektivisch dargestellt.

## Patentansprüche

1. Anzeigeeinheit (1) mit einem durchleuchtbaren Anzeigeelement (2), auf dessen Rückseite eine Lichtquelle (7) und zwischen Lichtquelle (7) und Anzeigeelementtein (2) ein Diffusor (4) angeordnet ist, wobei zwischen der Lichtquelle (7) und dem Anzeigeelement (2) ein in etwa scheibenförmiges, lichtklares Element (5) angeordnet ist, dessen dem Anzeigeelement (2) zugewandte Oberfläche (6) in etwa pyramidenförmig gerastert ist und an dessen dem Anzeigeelement (2) abgewandten Seite der Diffusor (4) angeordnet ist, **dadurch gekennzeichnet, daß** der Diffusor (4) ein einziges 2-Komponenten Spritzbauteil aus Kunststoff bildend mit dem licht-klaren Element (5) in der Weise verbunden ist, daß zwischen Diffusor (4) und lichtklarem Element (5) keine Lichübergangsfläche vorhanden ist.

2. Anzeigeeinheit nach Anspruch 1, **dadurch gekennzeichnet, daß** das Anzeigeelement (2) eine Sichtscheibe ist.

3. Anzeigeeinheit nach Anspruch 2, **dadurch gekennzeichnet, daß** die Sichtscheibe farbig ist.

4. Anzeigeeinheit nach einem der Ansprüche 2 oder 3, **dadurch gekennzeichnet, daß** die Sichtscheibe Symbole und/oder Schriftzeichen aufweist.

5. Anzeigeeinheit nach Anspruch 1, **dadurch gekennzeichnet, daß** das Anzeigeelement (2) eine Flüssigkristallzelle ist.

6. Anzeigeeinheit nach einem der Ansprüche 1 bis 5, **dadurch gekennzeichnet, daß** der Diffusor (4) aus einem transparenten Werkstoff besteht, in dem verteilt Streupigmente oder Streuteilchen angeordnet sind.

7. Anzeigeeinheit nach einem der vorhergehenden Ansprüche, **dadurch gekennzeichnet, daß** der Diffusor (4) scheibenförmig ist.

8. Anzeigeeinheit nach einem der vorhergehenden Ansprüche, **dadurch gekennzeichnet, daß** der Diffusor (4) farbig ist.

9. Anzeigeeinheit nach einem der vorhergehenden Ansprüche, **dadurch gekennzeichnet, daß** die Lichtquelle (7) eine LED oder eine Glühlampe ist.

10. Anzeigeeinheit nach einem der Ansprüche 1 bis 8, **dadurch gekennzeichnet, daß** die Lichtquelle (7) eine Leuchtstofflampe ist.

11. Anzeigeeinheit nach einem der vorhergehenden Ansprüche, **dadurch gekennzeichnet, daß** die Lichtquelle (7) farbiges Licht ausstrahlt.

12. Anzeigeeinheit nach einem der vorhergehenden Ansprüche, **dadurch gekennzeichnet, daß** die in etwa pyramidenförmige Rasterung der Oberfläche (6) des lichtklaren Elements (5) Pyramiden mit quadratischer oder rechteckiger Grundfläche aufweist.

13. Anzeigeeinheit nach einem der vorhergehenden Ansprüche, **dadurch gekennzeichnet, daß** die in etwa pyramidenförmige Rasterung der Oberfläche (6) des lichtklaren Elements (5) Pyramiden mit drei- oder mehreckiger Grundfläche aufweist.

14. Anzeigeeinheit nach einem der vorhergehenden Ansprüche, **dadurch gekennzeichnet, daß** die in etwa pyramidenförmige Rasterung der Oberfläche (6) des lichtklaren Elements (5) Pyramidenstümpfe aufweist.

15. Anzeigeeinheit nach einem der vorhergehenden Ansprüche, **dadurch gekennzeichnet, daß** die in etwa pyramidenförmige Rasterung der Oberfläche (6) des lichtklaren Elements (5) Pyramiden und/oder Pyramidenstümpfe mit einheitlicher Grundfläche und Höhe aufweist.

16. Anzeigeeinheit nach einem der Ansprüche 1 bis 14, **dadurch gekennzeichnet, daß** die in etwa pyramidenförmige Rasterung der Oberfläche (6) des lichtklaren Elements (5) Pyramiden und/oder Pyramidenstümpfe mit unterschiedlicher Grundfläche und/oder Höhe aufweist.

17. Anzeigeeinheit nach einem der vorhergehenden Ansprüche, **dadurch gekennzeichnet, daß** das lichtklare Element (5) eine Codierung (8) aufweist.

## Claims

1. Display unit (1) having a display element (2) that can be transilluminated and on whose rear a light source (7) is arranged and a diffuser (4) is arranged between light source (7) and display element (2), an approximately panel-like transparent element (5) being arranged between the light source (7) and the display element (2), its surface (6) facing the display element (2) being patterned approximately in a pyramid shape and the diffuser (4) being arranged on its side facing away from the display element (2), **characterized in that** the diffuser (4) is connected to the transparent element (5), forming a single two-component injection-moulded component made of plastic, in such a manner that there is no light transmission surface between diffuser (4) and transparent element (5).

2. Display unit according to Claim 1, **characterized in that** the display element (2) is a display panel.

3. Display unit according to Claim 2, **characterized in that** the display panel is coloured.

4. Display unit according to either of Claims 2 and 3, **characterized in that** the display panel has symbols and/or characters.

5. Display unit according to Claim 1, **characterized in that** the display element (2) is a liquid crystal cell.

6. Display unit according to one of Claims 1 to 5, **characterized in that** the diffuser (4) consists of transparent material, in which scattering pigments or scattering particles are arranged in a distributed manner.

7. Display unit according to one of the preceding claims, **characterized in that** the diffuser (4) is panel-like.

8. Display unit according to one of the preceding claims, **characterized in that** the diffuser (4) is coloured.

9. Display unit according to one of the preceding claims, **characterized in that** the light source (7) is an LED or an incandescent lamp.

10. Display unit according to one of Claims 1 to 8, **characterized in that** the light source (7) is a fluorescent lamp.

11. Display unit according to one of the preceding claims, **characterized in that** the light source (7) emits coloured light.

12. Display unit according to one of the preceding claims, **characterized in that** the approximately pyramid patterning of the surface (6) of the transparent element (5) has pyramids with a square or rectangular outline.

13. Display unit according to one of the preceding claims, **characterized in that** the approximately pyramid patterning of the surface (6) of the transparent element (5) has pyramids with a triangular or polygonal outline.

14. Display unit according to one of the preceding claims, **characterized in that** the approximately pyramid patterning of the surface (6) of the transparent element (5) has truncated pyramids.

15. Display unit according to one of the preceding claims, **characterized in that** the approximately pyramid patterning of the surface (6) of the transparent element (5) has pyramids and/or truncated pyramids with a uniform outline and height.

16. Display unit according to one of Claims 1 to 14, **characterized in that** the approximately pyramid patterning of the surface (6) of the transparent element (5) has pyramids and/or truncated pyramids with a different outline and/or height.

17. Display unit according to one of the preceding claims, **characterized in that** the transparent element (5) has a coding means (8).

## Revendications

1. Unité d'affichage (1) comportant un élément d'affichage transparent (2), au dos duquel est placée une source lumineuse (7), et un diffuseur (4) est placé entre la source lumineuse (7) et l'unité d'affichage (2), un élément transparent (5) ayant sensiblement la forme d'un disque étant placé entre la source lumineuse (7) et l'élément d'affichage (2), élément dont la surface (6) toumée vers l'élément d'affichage (2) porte un réseau à structure sensiblement en pyramides et sur le côté duquel opposé à l'élément d'affichage (2) est placé le diffuseur (4), **caractérisée en ce que** le diffuseur (4) est relié à l'élément transparent (5) en formant une pièce unique moulée par injection à deux composants en matière synthétique, de telle manière qu'il n'existe pas de surface de transition lumineuse entre le diffuseur (4) et l'élément transparent (5).

2. Unité d'affichage selon la revendication 1, **caractérisée en que** l'élément d'affichage (2) est un disque visible.

3. Unité d'affichage selon la revendication 2, **caractérisée en ce que** le disque visible est coloré.

4. Unité d'affichage selon l'une des revendications 2 ou 3, **caractérisée en ce que** le disque visible porte des symboles et/ou des inscriptions.

5. Unité d'affichage selon la revendication 1, **caractérisée en ce que** l'élément d'affichage (2) est une cellule de cristaux liquides.

6. Unité d'affichage selon l'une des revendications 1 à 5, **caractérisée en ce que** le diffuseur (4) est réalisé en une matière transparente dans laquelle sont répartis des pigments dispersifs ou des particules dispersives.

7. Unité d'affichage selon l'une des revendications précédentes, **caractérisée en ce que** le diffuseur (4) a la forme d'un disque.

8. Unité d'affichage selon l'une des revendications précédentes, **caractérisée en ce que** le diffuseur (4) est coloré.

9. Unité d'affichage selon l'une des revendications précédentes, **caractérisée en ce que** la source lumineuse (7) est un LED ou une lampe à incandescence.

10. Unité d'affichage selon l'une des revendications 1 à 8, **caractérisée en ce que** la source lumineuse (7) est une lampe fluorescente.

11. Unité d'affichage selon l'une des revendications précédentes, **caractérisée en ce que** la source lumineuse (7) rayonne une lumière colorée.

12. Unité d'affichage selon l'une des revendications précédentes, **caractérisée en ce que** le réseau à structure sensiblement en pyramides de la surface (6) de l'élément transparent (5) comporte des pyramides à base carrée ou rectangulaire.

13. Unité d'affichage selon l'une des revendications précédentes, **caractérisée en ce que** le réseau à structure sensiblement en pyramides de la surface (6) de l'élément transparent (5) comporte des pyramides à base triangulaire ou polygonale.

14. Unité d'affichage selon l'une des revendications précédentes, **caractérisée en ce que** le réseau à structure sensiblement en pyramides de la surface (6) de l'élément transparent (5) comporte des troncs de pyramide.

15. Unité d'affichage selon l'une des revendications précédentes, **caractérisée en ce que** le réseau à structure sensiblement en pyramides de la surface (6) de l'élément transparent (5) comporte des pyramides et/ou des troncs de pyramide ayant une base et une hauteur uniformes.

16. Unité d'affichage selon l'une des revendications 1 à 14, **caractérisée en ce que** dans le réseau à structure sensiblement en pyramides de la surface (6) de l'élément transparent (5) comporte des pyramides et/ou des troncs de pyramide ayant des bases et/ou des hauteurs différentes.

17. Unité d'affichage selon l'une des revendications précédentes, **caractérisée en ce que** l'élément transparent (5) comporte un codage (8).
